# EUROPEAN PATENT APPLICATION

(11) **EP 1 933 120 A2**
(43) Date of publication of application: **18.06.2008**
(21) Application number: 07121709.5
(22) Date of filing: 28.11.2007
(51) Int. Cl.: G01J 5/12

(54) **Radiation sensor**

(30) Priority: 04.12.2006 US 566405
(71) Applicant: General Electric Company, Schenectady, NY 12345 (US)
(72) Inventor: Krellner, Theodore J., Emporium, PA 15834 (US); Straub, Peter J., St. Mary's, PA 15857 (US); Twiney, Robert, Fivehead, Somerset TA3 6PF (GB)
(74) Representative: Illingworth-Law, William Illingworth

(57) **Abstract**

A method of making a radiation sensor wherein a plurality of thermopiles are formed on one wafer and a plurality of packages for the thermopiles are formed in another wafer. Each package includes a formed well covered by a window. The two wafers are bonded in a controlled gas or vacuum environment such that each thermopile resides in the well below the window of a package.

## Description

### FIELD OF THE INVENTION

This subject invention relates to sensors such as infrared sensors.

### BACKGROUND OF THE INVENTION

A typical infrared sensor includes a thermopile formed by semiconductor processes in silicon. See U.S. Patent No. 6,987,223 incorporated herein by this reference. The thermopile is bonded to a base and then covered with a TO style can or package. The lid of the TO can is perforated to produce an opening then covered by a window or filter attached to the TO can lid over the opening. The TO package serves to maintain the thermopile in a controlled environment. Changes in the thermal conductivity of the gas in the can change the response of the sensor. So, the TO can is typically filled with a dry inert gas or subjected to a vacuum. The resulting package allows infrared radiation ingress through the filter while protecting the infrared sensor or thermopile from changes in the environment.

To manufacture such a sensor, semiconductor processes are used to make the thermopiles. Then, the thermopile is removed from the semiconductor fabrication area. Next, the TO cans are prepared, the lids are fitted with the filters, the thermopiles are bonded to the base, the required electrical connections are made, and the can is welded to the base. The result is a process which often requires significant manual labor. The TO can package used is not conducive to placement with modem automated circuit board assembly equipment. Also, the TO can packaging technique significantly increases the size of the sensor and can add cost without adding significant value. Finally, the TO can package system is not always hermetically sealed and the content of the gas envelope within the TO can may change over time adversely effecting the performance of the thermopile.

### SUMMARY OF THE INVENTION

According to one aspect of this invention, a complete sensor is provided which can be fabricated using semiconductor processes throughout. The need for a TO style can is eliminated. The method produces a better hermetically sealed environment about the thermopile. The method reduces the amount of manual labor associated with the production of sensors. The sensor can be made smaller and at a lower cost.

The subject invention results from the realization that a better, lower cost sensor is effected by eliminating the prior art TO can and instead providing a package fabricated using semiconductor production techniques wherein a well is formed (typically etched) in a substrate (typically silicon) to be bonded to the substrate of the thermopile.

The subject invention, however, in other embodiments, need not achieve all these objectives and the claims hereof should not be limited to structures or methods capable of achieving these objectives.

The subject invention features a method of making a radiation sensor. On one wafer, a plurality of thermopiles are formed. In another wafer, a plurality of packages for the thermopiles are formed, each package including a well covered by a window. Since silicon is a naturally IR transmissive material it is possible for the silicon wafer to act as the window, and its IR transmission can be further enhanced by use of suitable antireflective coatings. The wafers are bonded in a controlled gas or vacuum environment such that each thermopile resides in the well below the window of a package.

Typically, the well of each package is formed by etching the wafer. A KOH etchant can be used to produce a well with angled sides. Alternately, a deep reactive ion etching process (DRIE) can be used to produce a parallel-sided well. The window usually serves as a filter, and in one variation, a wavelength dependent filter. In one example, the window is bonded to the well. In another example, the window is integral with the well and produced by etching only partially into the wafer.

The wafers may be bonded to each other and then diced to produce individual radiation sensors. Another wafer may be bonded to the wafer including the plurality of thermopiles, either before or after the wafer including the plurality of thermopiles and the wafer including the plurality of packages are bonded together.

One method of making a radiation sensor in accordance with this invention features forming a thermopile, forming a package for the thermopile including a well formed in a semiconductor material covered by a window, and then bonding the package to the thermopile in a controlled gas or vacuum environment.

A radiation sensor in accordance with this invention includes a thermopile, a package for the thermopile including a well over the thermopile formed in a semiconductor material and a window covering the well, and a controlled gas or vacuum in the well.

Typically, the semiconductor material is silicon and the well is etched.

The typical window serves as a filter. In one variation, the radiation sensor may also include a wafer under the thermopile, and/or the package for the thermopile may include a hole.

In one example, the window is a separate piece bonded to the well. In another example, the window is integral with the well and formed by only partially etching the silicon substrate. The well may have angled or straight sides.

### BRIEF DESCRIPTION OF THE SEVERAL VIEWS OF THE DRAWINGS

Other features and advantages will occur to those skilled in the art from the following description of a preferred embodiment, provided by way of example only, and the accompanying drawings, in which:
Fig. 1 is a schematic three-dimensional front view of a typical prior art infrared sensor TO can package;
Fig. 2 is a schematic cross-sectional front view showing a typical thermopile structure housed within the package shown in Fig. 1;
Figs. 3A-3C are schematic partial cross-sectional views showing one embodiment of how a wafer can be processed in accordance with the subject invention to produce a semiconductor style sensor package;
Fig. 4 is a schematic highly conceptual view showing one embodiment of how a wafer containing etched well sensor packages can be bonded to a wafer containing the thermopiles in a controlled gas inert or vacuum environment in accordance with the subject invention;
Fig. 5 is a schematic front cross-sectional view showing one example of a complete infrared sensor manufactured in accordance with the subject invention;
Figs. 6A-6B are schematic partial cross-sectional views showing how a wafer can be processed in accordance with another embodiment of the subject invention to produce a semiconductor style sensor package with an integral filter/window;
Fig. 7 is a schematic front cross-sectional view showing another example of a complete infrared sensor manufactured in accordance with the subject invention;
Fig. 8 is a schematic partial cross-sectional view showing masking in accordance with one embodiment of the subject invention;
Fig. 9 is a schematic front cross-sectional view showing another example of a complete infrared sensor manufactured in accordance with the subject invention; and
Fig. 10 illustrates an infrared sensor in accordance with a still further embodiment of the subject invention.

### DETAILED DESCRIPTION OF THE INVENTION

Aside from the preferred embodiment or embodiments disclosed below, this invention is capable of other embodiments and of being practiced or being carried out in various ways. Thus, it is to be understood that the invention is not limited in its application to the details of construction and the arrangements of components set forth in the following description or illustrated in the drawings. If only one embodiment is described herein, the claims hereof are not to be limited to that embodiment. Moreover, the claims hereof are not to be read restrictively unless there is clear and convincing evidence manifesting a certain exclusion, restriction, or disclaimer.

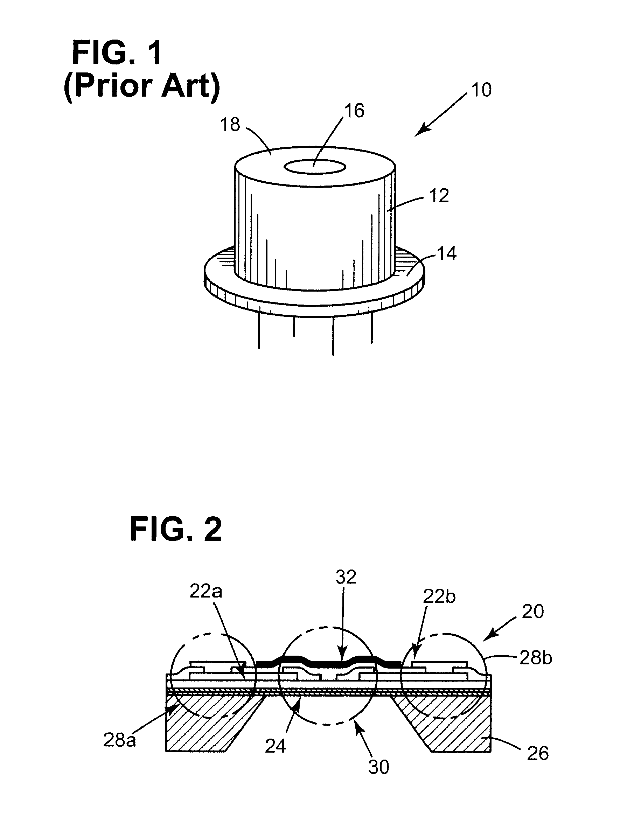

Fig. 1 shows prior art infrared sensor 10 which includes TO can 12 welded to base 14. TO can 12 lid 18 includes filter 16 attached thereto over an opening in lid 18. Inside can 12 on base 14 is thermopile structure 20, Fig. 2. The construction of thermopile 20 can vary but it typically includes thermal elements 22a and 22b, diaphragm or membrane 24 (e.g., layers of a dielectric, p-silicon, and other materials), and silicon heat sink 26 forming cold junctions 28a and 28b and hot junction 30 with absorber 32.

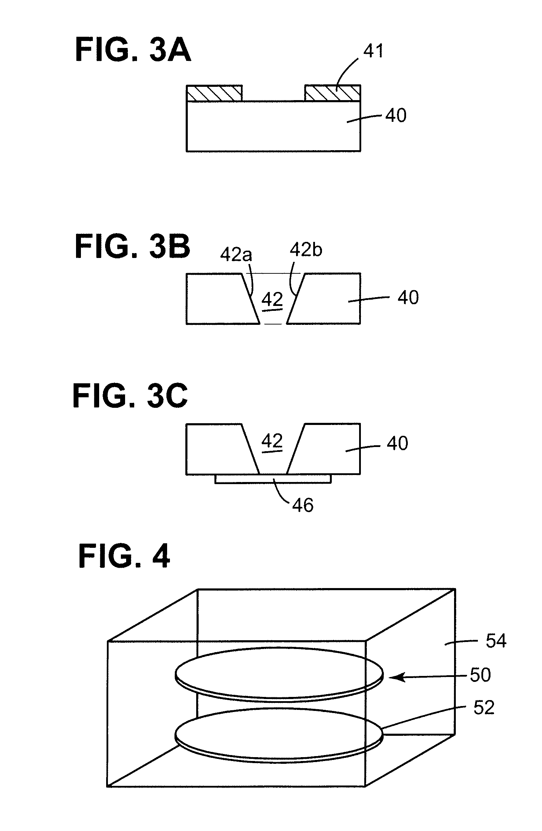

The subject invention eliminates the TO can style package commonly used for infrared and other sensors. Instead, in one preferred embodiment, a semiconductor, typically a silicon wafer substrate 40, Fig. 3A is masked as shown at 41 and then etched as shown in Fig. 3B to produce well 42. When KOH etching processes are used, angled well walls 42a, 42b can be formed. Alternatively, deep reactive ion etching (DRIE) can be used to produce straight walls. Next, filter 46 is bonded, using silicon bonding techniques, for example, over well 42, Fig. 3C. Numerous filters are known to those skilled in the art including wavelength dependent filters and broad and narrow band pass filters made of silicon, sapphire, and other materials.

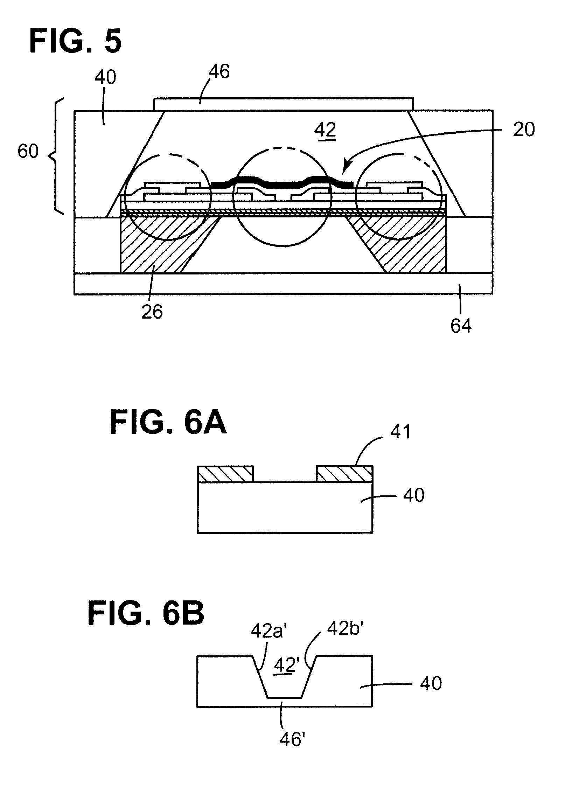

Then, wafer 50 containing a number of these formed packages is bonded to wafer 52 processed to include a like number of thermopiles as shown in Fig. 2. By bonding the two wafers in a controlled gas environment 54 or, alternatively in a vacuum, the result, after dicing, is a controlled gas in well 42, Fig. 5 and a hermetic seal between package 60 and thermopile structure 20.

In this example, silicon was used as the preferred sensor package material but other materials typically used in the semiconductor industry and in semiconductor processing techniques may be suitable. Thus, by the phrase "semiconductor material", we mean those material typically used in the semiconductor industry including materials used in the fabrication of microelectromechanical structures. In one variation, a base 64, such as another wafer or a printed circuit board, for example, may be added to the sensor and the associated wiring, leads, and pins or other electrical connections formed as required either before the two wafers are bonded or thereafter. Base 64 may serve as a mounting surface, and in the case of a wafer, it may be sealed by bonding in a controlled gas environment or vacuum as discussed above. In general, the deeper cavity 42, the more sensitive the resulting thermopile. The sensor can then be packaged in a standard semiconductor package or integrated into a circuit using chip scale packaging techniques.

The result is a complete sensor fabricated using semiconductor processes eliminating the need for a TO style can and the reducing the amount of manual labor associated with the production of sensors. The hermetic seal about the thermopile is better, thereby providing greater reliability. Further, the sensors are smaller, and, when manufactured on a large scale, the sensors can be produced at a reduced cost.

In another version, a semiconductor material 40, Fig. 6A is masked as shown at 41 and then partially etched as shown in Fig. 6B to produce well 42' and integral window/filter 46'. Appropriate etch control techniques are known to those skilled in the art to produce window/filter 46' of a desired thickness.

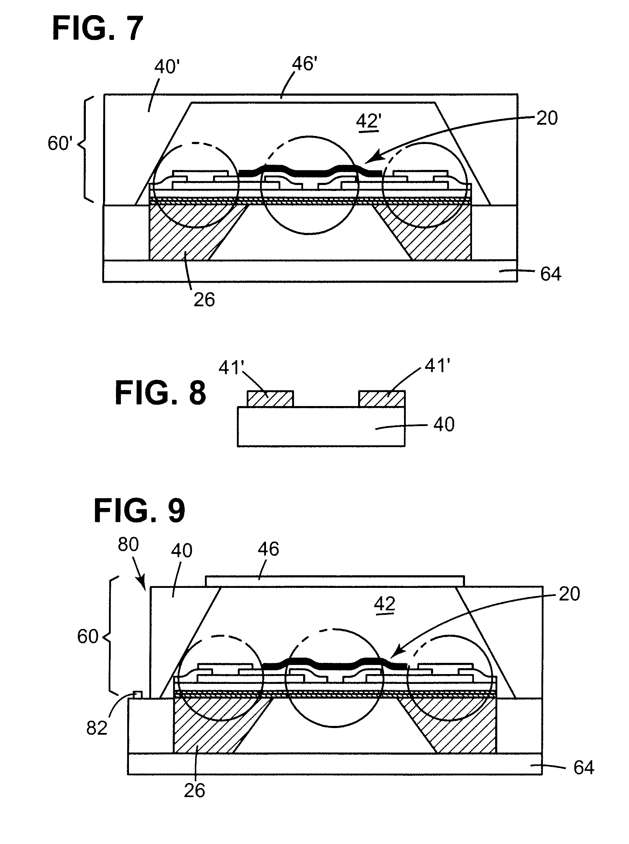

Then, as described above, a wafer containing a number of these formed packages is bonded to a wafer processed to include a like number of thermopiles as shown in Fig. 2. By bonding the two wafers in a controlled gas environment or, alternatively in a vacuum, the result, after dicing, is a controlled gas in well 42', Fig. 7 and a hermetic seal between package 60' and thermopile structure 20. Package 60' now includes integral window/filter 46'. If silicon is not the preferred filter material, filter 46' can be coated if necessary.

In another embodiment, semiconductor material 40, Fig. 8 is masked as shown at 41' and then etched to form a silicon cup (as shown) or hole (not shown) 80, Fig. 9, for eventual placement of contact pads 82 for example.

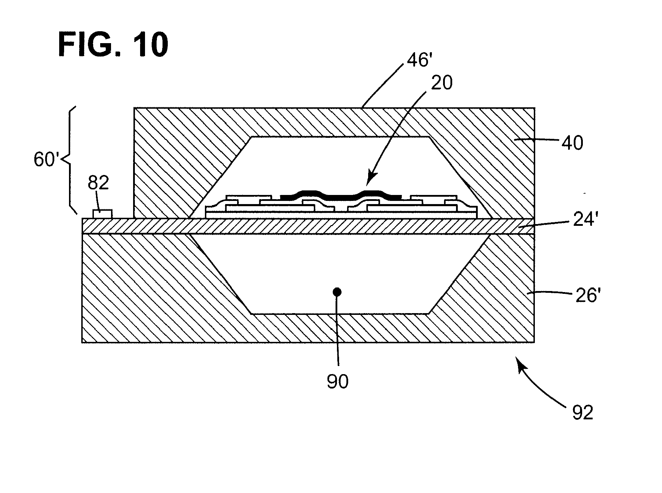

In a still further embodiment illustrated in Fig. 10, a silicon base 26' for the thermopile 20 is formed by first etching cavities 90 in a wafer 92 using KOH or DRIE techniques, for example. A second wafer is bonded to the first wafer 92 and most of the second wafer is etched away to leave a thin diaphragm 24'. The thermopile 20 and associated electrical connections are formed on the diaphragm layer 24'. Finally, a cap of semiconductor material 40 such as formed as described above in Fig. 8 is bonded over the thin diaphragm 24' and thermopile 20 to the silicon base 26' of the first layer 90. The cap 40 is bonded to the thin diaphragm 24' after the diaphragm 24' has been bonded to silicon base 26' in the manner described above to capture a controlled gas environment or to create a vacuum about thermopile 20.

Although specific features of the invention are shown in some drawings and not in others, this is for convenience only as each feature may be combined with any or all of the other features in accordance with the invention. The words "including", "comprising", "having", and "with" as used herein are to be interpreted broadly and comprehensively and are not limited to any physical interconnection. Moreover, any embodiments disclosed in the subject application are not to be taken as the only possible embodiments. Other embodiments will occur to those skilled in the art and are within the following claims.

This written description uses examples to disclose the invention, including the best mode, and also to enable any person skilled in the art to make and use the invention. The patentable scope of the invention is defined by the claims, and may include other examples that occur to those skilled in the art. Such other examples are intended to be within the scope of the claims if they have structural elements that do not differ from the literal language of the claims, or if they include equivalent structural elements with insubstantial differences from the literal languages of the claims.

In addition, any amendment presented during the prosecution of the patent application for this patent is not a disclaimer of any claim element presented in the application as filed: those skilled in the art cannot reasonably be expected to draft a claim that would literally encompass all possible equivalents, many equivalents will be unforeseeable at the time of the amendment and are beyond a fair interpretation of what is to be surrendered (if anything), the rationale underlying the amendment may bear no more than a tangential relation to many equivalents, and/or there are many other reasons the applicant can not be expected to describe certain insubstantial substitutes for any claim element amended.

## Claims

1. A method of making a radiation sensor, the method comprising:
forming on one wafer a plurality of thermopiles;
forming in another wafer a plurality of packages for the thermopiles, each package including a formed well covered by a window;
bonding the wafers in a controlled gas or vacuum environment such that each thermopile resides in the well below the window of a package.

2. The method of claim 1 in which the well of each package is formed by etching the wafer.

3. The method of claim 1 or claim 2, in which the window includes a wavelength dependent filter.

4. A method of making a radiation sensor, the method comprising:
forming a thermopile;
forming a package for the thermopile including a well formed in a semiconductor material covered by a window; and
bonding the package to the thermopile in a controlled gas or vacuum environment.

5. The method of any one of the preceding claims in which the well is etched in a silicon substrate.

6. The method of claim 4 further including the step of bonding a wafer to the thermopile.

7. A radiation sensor comprising:
a thermopile;
a package for the thermopile including a well over the thermopile formed in a semiconductor material and a window covering the well; and
a controlled gas or vacuum in the well.

8. The sensor of claim 7in which the semiconductor material is silicon.

9. The sensor of claim 7or claim 8 in which the package includes a hole for contact pads.

10. The sensor of any one of claims 7 to 9 further including a wafer over the thermopile.
